(19) Europäisches Patentamt / European Patent Office / Office européen des brevets

(11) **EP 4 434 939 A1**

(12) **EUROPEAN PATENT APPLICATION**
published in accordance with Art. 153(4) EPC

(43) Date of publication:
**25.09.2024 Bulletin 2024/39**

(21) Application number: **23743178.8**

(22) Date of filing: **13.01.2023**

(51) International Patent Classification (IPC):
**C01B 33/035** (2006.01)

(52) Cooperative Patent Classification (CPC):
**C01B 33/035**

(86) International application number:
**PCT/JP2023/000746**

(87) International publication number:
**WO 2023/140184 (27.07.2023 Gazette 2023/30)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.01.2022 JP 2022005553**

(71) Applicant: **TOKUYAMA CORPORATION**
**Yamaguchi 745-8648 (JP)**

(72) Inventors:
• **NAKAMURA, Ryota**
**Shunan-shi, Yamaguchi 745-8648 (JP)**
• **ISHIKAWA, Koichi**
**Shunan-shi, Yamaguchi 745-8648 (JP)**

(74) Representative: **Canzler & Bergmeier**
**Patentanwälte**
**Partnerschaft mbB**
**Despag-Straße 6**
**85055 Ingolstadt (DE)**

(54) **REACTION FURNACE FOR PRODUCING POLYCRYSTALLINE SILICON ROD, GAS SUPPLY NOZZLE, PRODUCTION METHOD OF POLYCRYSTALLINE SILICON ROD, AND POLYCRYSTALLINE SILICON ROD**

(57) To provide a reaction furnace for producing a high-purity polycrystalline silicon rod with reduced contamination with impurity elements such as metallic elements and carbon, and a method for producing a polycrystalline silicon rod using the reaction furnace. A reaction furnace for producing a polycrystalline silicon rod, the interior of which is hermetically sealed by a bell jar and a bottom plate, wherein the bottom plate is provided with a plurality of electrode pairs for holding a silicon core wire and energizing the silicon core wire, and the bottom plate is further provided with a plurality of gas supply nozzles, each with a tip jet upward, for supplying a starting material gas for silicon deposition into the interior space of the bell jar, characterized in that at least a part of the surface of the gas supply nozzles in contact with the interior space of the bell jar is composed of quartz including a roughened surface area having a ten point average roughness Rz of 1.0-5.0 $\mu$m.

FIG.1

Exhaust gas    Raw material gas

EP 4 434 939 A1

**Description**

TECHNICAL FIELD

The present disclosure relates to a reaction furnace for producing a polycrystalline silicon rod for depositing a polycrystalline silicon onto a silicon core wire placed in the reaction furnace using a chemical vapor deposition method. The present disclosure also relates to a nozzle for supplying a reaction gas into the reaction furnace, and relates to a production method of the polycrystalline silicon rod using the reaction furnace. Further, the present disclosure relates to a polycrystalline silicon rod.

BACKGROUND

Conventionally, there are various known methods for producing silicon which is used as a raw material of a semiconductor wafer or a solar photovoltaic wafer, and some of these are already used industrially. For example, one of these is a so-called of Siemens method, in which a silicon core wire is placed in a reaction furnace, and the reaction core wire is heated to a silicon deposition temperature by supplying electric power to the silicon core wire. Then, while in this state, a silicon deposition raw material gas comprising a reducing gas and a silane compound such as trichlorosilane ($SiHCl_3$), monosilane ($SiH_4$), and so on are supplied into the reaction furnace, and silicon is deposited on the silicon core wire using a chemical vapor deposition method. The advantage of this method is that a high-purity polycrystalline silicon can be obtained in a form of a rod, and this method is the most commonly performed method.

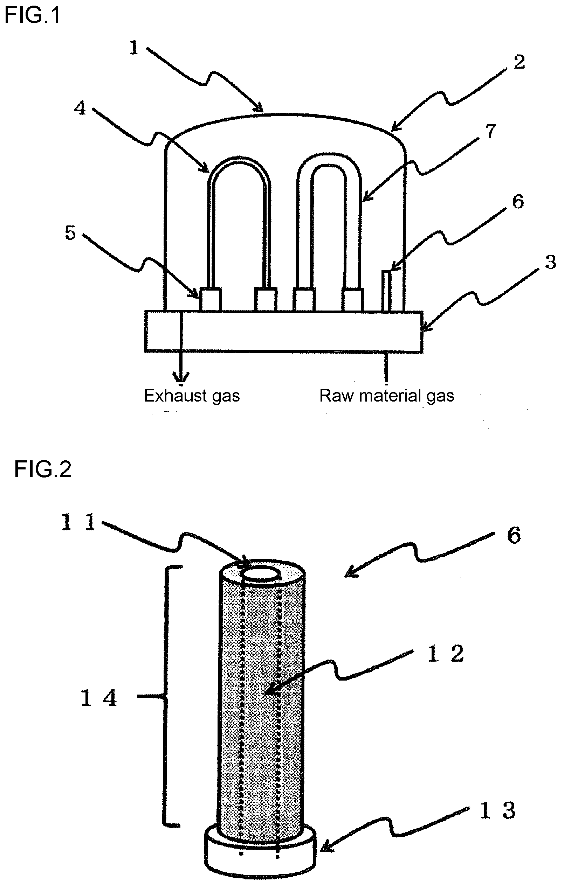

In order to industrially perform Siemens method, the reaction furnace generally has a structure as indicated in FIG. 1. That is, inside of a reaction furnace 1 is sealed by a bell jar 2 and the base plate 3, and the base plate 3 holds a plurality of silicon core wires 4 and also the base plate 3 is provided with an electrode pair 5 for supplying electric power to the silicon core wire 4. Further, the base plate 3 is provided with a plurality of gas supply nozzles 6, each having an injection tip opening facing upwards, for supplying the silicon deposition raw material gas to the internal space of the bell jar 2 (see Patent Document 1). Note that, in FIG. 1, only one gas supply nozzle 6 is shown, however, in an actual machine, a plurality of gas supply nozzles 6 are equally spaced apart on an upper face of the base plate 3.

The polycrystalline silicon used as a raw material of the semiconductor wafer or a solar photovoltaic wafer needs to be highly pure with low impurity concentration. Specifically, for a semiconductor wafer, those having high resistance such as a specific resistance of 1000 S2cm or higher is demanded; and for a solar photovoltaic wafer, 300 S2cm or higher is demanded. Here, as the impurities which may be mixed into the polycrystalline silicon, dopants such ash P, B, and so on may be mainly mentioned. In addition to these, impurities which influence the yield as a semiconductor purpose, metals such as Fe, Ni, Cr, and so on, and carbon may be mentioned.

For example, in order to reduce the impurities derived from the raw materials, many technologies are disclosed to refine the silane-based compound as the raw material (for example, see Patent Document 2).

The raw materials may not be the only source of the impurities, and the impurities may be mixed from the polycrystalline silicon production device. That is, during the steps of the polycrystalline silicon production, when the silicon core wire is heated, and when an electric power is supplied to the silicon core wire and the chemical vapor deposition proceeds, the temperature inside the reaction chamber becomes extremely high. Further, while the chemical vapor deposition is in progress, inside of the reaction chamber is at high temperature and exposed to a by-product gas (a gas of silane-based compound, hydrogen gas, tetrachlorosilane, hydrochloride, and so on) generated by the reaction with a reactive gas. In general, inorganic materials such as stainless steel, carbon, and so on are used as members used for the polycrystalline silicon production device such as a furnace material of inner wall of the bell jar furnace, electrodes provided inside the bell jar, nozzle, holder, and so on. The stainless steel includes Fe as a main component, and also includes metals such as Cr, and so on. The carbon member includes carbon as a main component, and also includes metals (such as Fe, Cr, Ni). When these inorganic materials contact with the reactive gas and the by-product gas at high temperature, the impurities are generated and released, metal silicide is deposited, and the inorganic materials deteriorate; hence, there is a risk that an impurity concentration in the obtained polycrystalline silicone may increase.

Hence, technologies to reduce the impurities derived from the polycrystalline silicon production device are also being studied. For example, Patent Document 3 discloses a nozzle which is coated by a coating layer to prevent the impurities generated from a carbon-made nozzle for supplying a raw material gas from mixing into the raw material gas. Also, Patent Document 4 discloses a method of refining a carbon member used for a polycrystalline silicon production to prevent the impurities derived from the carbon member used for the polycrystalline silicon production device from being mixed into the silicon rod.

Also, when completing the silicon deposition by stopping the electrical power supply, the amount of electrical power supply is adjusted for cooling. Silicon has a property that the higher the temperature is, the higher the electrical resistivity; thus, the electrical resistivity of the cooled surface rapidly decreases due to heat dissipation, and current concentrates at the center part of the silicon rod which causes wide temperature differences between the center part and the surface while proceeding cooling. As a result, a large residual stress remains in the silicon rod, and a risk of rupturing by external force increases after cooling. Thus, among the monocrystalline silicon production raw material usages, it is not suitable as a raw material for a FZ method raw material and a silicon rod for recharging, and the risk of the silicon rod breaking before taking out of the reaction furnace increases. Patent Document 5 proposes a heat treatment (annealing) technology which changes atmosphere before cooling begins to a low thermal conductivity atmosphere such as hydrogen, then the silicon rod surface is placed under high temperature of 1030°C or higher for appropriate length of time to equalize the temperatures of the center part and the surface, and the electrical power supply rapidly decreased.

PRIORITY DOCUMENTS

Patent Document 1: JP Patent Application Laid Open No.2013-63884

Patent Document 2: JP Patent No.5368909

Patent Document 3: JP Patent No.5182608

Patent Document 4: JP Patent No.5428692

Patent Document 5: JP Patent No.3357675

SUMMARY

In recent years, higher performance and miniaturization of a semiconductor wafer has progressed. Along with that, it is demanded to strictly reduce the above-mentioned impurity elements from being included in the polycrystalline silicon as a semiconductor material. Specifically, a quality control at a level of several ppt is demanded, and in addition to the above members, a method for preventing the impurity elements from mixing is also demanded.
That is, the object of the present disclosure is to provide a reaction furnace and a gas supply nozzle for producing a high-purity polycrystalline silicon rod with reduced amount of the impurity elements such as metal elements and carbon; and also, to provide a method for producing a polycrystalline silicon rod using the reaction furnace.

MEANS FOR SOLVING THE OBJECTS

The present inventors have carried out keen study in view of the above-mentioned object. When the state of a metal component during the polycrystalline silicon production steps using Siemens method is examined, metal compounds was confirmed. As a result of keen study regarding a method for reducing the by-product of the metal compounds, it was found that the by-product amount of the metal compounds can be reduced by changing the material near a gas supply opening of a gas supply nozzle to quartz from carbon. However, when the material of the gas supply nozzle was changed and quartz for depositing silicon, then, it was also found that the appearance damage occurred on the deposited silicon rod.
As a result of keen study, by forming a rough surface part to a surface near the gas supply opening of the gas supply nozzle which has been changed to quartz, it was found that the appearance damage of the deposited silicon rod can be reduced, thereby, the preset invention has been achieved.
That is, the first aspect of the present invention is a reaction furnace for producing a polycrystalline silicon rod, including;

a bell jar and a base plate which seal inside of the reaction furnace, wherein
the base plate includes a plurality of electrode pairs holding a silicon core wire and supplying electric power to the silicon core wire, and
the base plate includes a plurality of gas supply nozzles, each having an injection tip opening facing upwards, for supplying a silicon deposition raw material gas to an internal space of the bell jar, wherein
at least part of a contacting surface of the gas supply nozzles contacting the internal space of the bell jar is configured of quartz including a rough surface part having a ten-point average roughness Rz of 1.0 to 5.0 $\mu$m.

The above-mentioned first aspect of the present invention may preferably include below embodiments.

(1-1) 50% or more of a surface area of the contacting surface of the gas supply nozzles is configured of quartz including the rough surface part.

(1-2) An arithmetic average surface roughness Ra of the rough surface part is 0.3 to 3.0 $\mu$m.

(1-3) The reaction furnace includes a supplying pipe for supplying the silicon deposition raw material gas to the gas supply nozzles, and

at least one of the gas supply nozzles and the supplying pipe include a removing means for removing impurities mixed in the silicon deposition raw material gas.

Also, the second aspect of the present invention is a gas supply nozzle for supplying a silicon deposition raw material gas from an injection tip opening into an internal space of a bell jar, wherein at least part of a contacting surface of the gas supply nozzle contacting the internal space of the bell jar is configured of quartz including a rough surface part having a ten-point average roughness Rz of 1.0 to 5.0 $\mu$m.

The above-mentioned second aspect of the present invention may preferably include below embodiments.

(2-1) 50% or more of a surface area of the contacting surface of the gas supply nozzles is configured of quartz including the rough surface part.

(2-2) An arithmetic average surface roughness Ra of the rough surface part is 0.3 to 3.0 $\mu$m.

Further, a third aspect of the present invention is a method for producing a polycrystalline silicon rod, including steps of;

placing a silicon core wire inside a bell jar, and

injecting a silicon deposition raw material gas onto the silicon core wire while supplying electric power to the silicon core wire to deposit polycrystalline silicon on the silicon core wire, wherein

the method for producing the polycrystalline rod uses the reaction furnace for producing the polycrystalline silicon rod according to any one of the above-mentioned first aspect of the present invention.

The method for producing the polycrystalline silicon rod according to the above-mentioned disclosure may preferably include steps of;

removing a gas supply nozzle in the reaction furnace for producing the polycrystalline silicon rod after the polycrystalline silicon is deposited, and

washing a surface of the removed gas supply nozzle contacting an internal space of the bell jar.

In method for producing the polycrystalline silicon rod according to the above-mentioned disclosure, preferably, the impurities mixed in a silicon deposition raw material gas may be removed using a removing means, and the silicon deposition raw material gas from which the impurities are removed may be injected on the silicon core wire.

The polycrystalline silicon rod may be preferably produced under an atmosphere satisfying a cleanliness of Class 1 to 3 defined by ISO 14644-1.

A fourth aspect of the present invention is a polycrystalline silicon rod, wherein an outer layer part which is 4 mm deep from a surface has a Fe concentration of 10.0pptw or less, or a Ni concentration of 2.0 pptw or less.

A volume average of Fe concentration may preferably be 10 pptw or less, or a Ni concentration may preferably be 2.0 pptw or less which are calculated from actual measured values in a core wire part, a middle part, and an outer layer part.

Also, a foreign object having a size of 0.5 to 10 cm and a height of 0.5 to 5.0 cm may preferably be two or less per 100000 cm$^2$ surface area of the polycrystalline silicon rod.

EFFECT OF THE INVENTION

By using the reaction furnace for producing the polycrystalline silicon rod of the present invention to produce the polycrystalline silicon rod using a siemens method, it is possible to industrially produce a high-purity polycrystalline silicon rod with a reduced amount of impurity elements such as metal elements and carbon mixed in.

It is not necessarily clearly understood why a high-purity polycrystalline silicon rod can be obtained using the reaction furnace of the present invention. The present inventors speculate the following as one possible reason. That is, as mentioned in above, when the polycrystalline silicon is deposited on the core wire surface inside the bell jar, the inside of the reaction furnace is under high temperature of about 1000°C for a long period of time, and also highly reactive gas such as hydrochloride is generated as a by-product. Thus, hydrochloride contacts a surface of stainless member, carbon member, and so on in the reaction furnace, and metal compounds are generated. The generated metal compounds evaporate and diffuse together with a gas flow inside the reaction furnace, and part of such metal compounds are thought to contaminate the silicon surface. Here, in general, the base plate, the electrode pairs, and so on are configured to suppress the reaction between the structural material and hydrochloride by running cooling water around the base plate, the electrode pairs, and so on to lower the surface temperature. However, the gas supply nozzle has a shape which protrudes into the reaction furnace which makes it difficult to arrange a cooling system, hence, the temperature tends to become high. Thus, in the case that a material including metal is used, even though the surface area of the gas supply nozzle is small, the contamination by the metal compounds produced as a by-product due to the above-mentioned mechanism is thought to be very high.

Further, by using an annealing technology which switches to atmosphere having low thermal conductivity such as hydrogen or so prior to the start of cooling, the temperatures of the silicon rod surface and surfaces of many other furnace members increase, and the metal compounds further evaporate. It is thought that part of the evaporated metal compounds diffuses due to the gas flow inside the reaction furnace and contaminates the silicon rod. Regarding the reaction furnace of the present invention, at least the material near the gas supply opening of the gas supply nozzle is a quartz member. The quartz member has a less content of the metal elements compared to the carbon member. Further, under the above-mentioned deposition condition of silicon, it is speculated that corrosion by hydrochloride does not occur, hence, the production of the metal compounds as by-products are thought to be reduced. Additionally, the quartz member has a relatively high transparency against radiant light from the silicon rod, hence, it is hard to heat, thereby the metal impurities as by-products are reduced. Therefore, even increasing the temperature of the furnace member surfaces prior to the start of cooling, a re-vaporization amount of the metal compounds is also thought to be reduced.

When a smoothed quartz is used for the gas supply nozzle, the adhesive force of the silicon deposited on the quartz surface is weak, thus, deposited silicon may be released by the gas flow inside the reaction furnace, and it also may be released due to the expansion deformation caused by a surface temperature change. The released silicon adheres onto the silicon rod, thereby, it is thought that the appearance of the silicon rod is damaged.

However, by roughening the quartz surface of the gas supply nozzle to some degree to increase a bonding area, release of the silicon deposited on the surface can be suppressed, and it is thought that the damage to the appearance of the silicon rod can be suppressed.

By using the reaction furnace of the present invention as mentioned in the above, it is possible to industrially produce the high-purity polycrystalline silicon rod, and thus, the industrial applicability of the present disclosure becomes extremely high.

BRIEF DESCRIPTION OF THE DRAWINGS

FIG. 1 is a schematic view showing a configuration of a reaction furnace for producing a polycrystalline silicon rod which is a representative embodiment used in the present disclosure.

FIG.2 is a perspective view of a gas supply nozzle suitably used in the reaction furnace for producing the polycrystalline silicon rod of the present disclosure.

FIG.3 is a cross-sectional view of one configuration in which a gas supply nozzle is placed in the reaction furnace for producing the polycrystalline silicon rod, which is a representative example of one embodiment of the present disclosure.

FIG.4 is a cross-sectional view of another configuration in which a gas supply nozzle placed in a reaction furnace for producing the polycrystalline silicon rod, which is a representative example of another embodiment of the present disclosure.

DETAILED DESCRIPTION

An embodiment of one aspect of the present invention is described in below; however, the present disclosure is not limited thereto. The present invention is not limited to each configuration described in below, and various modifications within the scope of the claims are possible. That is, an embodiment obtained by combining technical means described in different embodiments is also within the scope of the present invention. Also, patent documents described in the present specification are included as references in those entireties. Also, unless mentioned otherwise, a numerical range shown by "A to B" means "A or larger (includes A and larger than A) and B or less (includes B and less than B)".

<Reaction Furnace For Producing Polycrystalline Silicon Rod>

In the present disclosure, a polycrystalline silicon rod is produced by following a so-called Siemens method, in which a silicon deposition raw material gas comprising a reducing gas and silane compounds such as trichlorosilane ($SiHCl_3$) and monosilane ($SiH_4$) is contacted onto a silicon core wire heated to a deposition temperature of silicon by supplying electric power; thereby silicon is deposited onto the silicon core wire by a chemical vapor deposition method. Regarding a reaction furnace, inside is sealed by a bell jar 2 and a base plate 3 as shown in FIG.1. The base plate 3 is provided with a plurality of electrode pairs 5 for holding a silicon core wire 4 and for supplying electric power to the silicon core wire 4; and the base plate 3 is also provided with a plurality of gas supply nozzles 6, each having an injection tip opening facing upwards, for supplying the silicon deposition raw material gas to an internal space of the bell jar 2. To the reaction furnace 1 having such configuration, the silicon deposition raw material gas is injected from the gas supply nozzles 6 while supplying electric power to the silicon core wire 4, therefore a polycrystalline silicon 7 is deposited onto the silicon core wire 4. Thereby, the polycrystalline silicon rod is produced.

<Gas Supply Nozzle>

FIG.2 is a perspective view of a gas supply nozzle used for the reaction furnace for producing the polycrystalline silicon rod of the present disclosure. The gas supply nozzle 6 has a configuration of a circular cylinder shape, and includes a gas supplying part 12 for supplying the silicon deposition raw material gas to the inside of the reaction furnace, and a joint part 13 which connects the gas supply nozzle 6 and the base plate. The silicon deposition raw material gas is supplied into the reaction furnace 1 from the gas supplying part 12 through the injection tip opening 11.

One of the characteristics of the present invention is that at least part of the contacting surface of a gas supply nozzle 6 with the internal space of the bell jar is made of quartz including a rough surface part 14 having a ten-point average roughness Rz of 1.0 to 5.0 $\mu$m. By using quartz, production of the metal compounds as by-products can be suppressed. In FIG.2, the entire gas supply nozzle is made of quartz, however, the part made of quartz in the gas supply nozzle is not particularly limited. For example, the gas supplying part supplying the silicon deposition raw material gas may be made by material other than quartz, and then two-layer structure can be employed which covers an outer circumference of the supplying part by quartz. Alternatively, a vicinity of the injection tip opening 11 of the gas supply nozzle (that is, the upper part of the gas supply nozzle standing in the reaction furnace 1) may be made of quartz, and the joint part 13 side can be made of other material. From the point of suppressing the production of the metal compounds as by-products, preferably, the upper part of the nozzle including the injection tip opening is made of quartz. Also, preferably, 50% or more of the surface area of the contacting surface is made of quartz. Also, as a gas introduction pathway, it may be a straight body shape in which the cross-section area does not change, it may be a shape in which the diameter changes by hot working the injection tip opening to adjust a gas flow rate, or it may be a shape that screw processing is performed to connect with other members. Note that, "contacting area" is a total area of the surface exposed to the internal space of the bell jar among the entire surface of the gas supply nozzle 6, and it means the total of the outer surface of the gas supply nozzle and the tip part of the nozzle. Thus, the inner surface of the nozzle and the part lower than the base plate 3 are not included in the calculation. However, the inner surface of the nozzle and the gas supply nozzle at a side lower than the base plate may also be made of quartz, and also may have the rough surface part.

Also, quartz of the gas supply nozzle in the reaction furnace for producing the polycrystalline silicon rod of the above-mentioned disclosure needs to include the rough surface part 14 having a ten-point average roughness Rz of 1.0 to 5.0 $\mu$m. If the surface of the gas supply nozzle is smoothed, the deposited silicon is weakly adhered on the surface of the smoothed surface, and the silicon is thought to be released due to the gas flow inside the reaction furnace and also due to expansion deformation caused by the surface temperature change. The gas supply nozzle of the present disclosure has a rough surface part which is formed of height differences; thus, the deposited silicon adheres onto the roughness parts, and releasing of the adhered silicon is suppressed. From the point of suppressing the release of the deposited silicon, the ten-point average roughness Rz of the rough surface part 14 may preferably be within a range of 1.5 to 5.0 $\mu$m, and particularly preferably may be within a range of 3.0 to 5.0 $\mu$m. When the ten-point average roughness Rz of the above-mentioned rough surface part is less than 1.0 $\mu$m, the effect of suppressing the release of the deposited silicon may not be sufficient, and the released silicon may cause appearance abnormality. Also, when the ten-point average roughness Rz of the rough surface part is larger 5.0 $\mu$m, durability may be compromised depending on the thickness of the member, also it may become difficult to remove the deposited silicon and possibly cause the metal contamination of the polycrystalline silicon when the gas supply nozzle is re-used for production. Further, during the deposition of silicon, transparency against the radiant light from the silicon rod declines significantly, the temperature of the gas supply nozzle itself increases, and the deposition of silicon including the metal impurities may be facilitated. Also, from the same point of view, an arithmetic average surface roughness Ra of the rough surface part 14 may preferably be within a range of 0.3 to 3.0 $\mu$m, more preferably within a range of 0.5 to 3.0 $\mu$m, and particularly preferably within a range of 1.0 to 3.0 $\mu$m.

A method for measuring the ten-point average roughness Rz of the rough surface part can be performed by transferring the quartz surface shape of the gas supply nozzle on a silicon rubber or so to make a replica of the rough surface part, and then observing the surface of the replica using an atomic force microscope (AFM) or so. Specifically, the image of the replica obtained from the observation using AFM is analyzed to make a roughness curve, and Rz is obtained from the differences between an average height of the highest five points higher than an average line and an average depth of the lowest five points lower than the average line. In FIG.2, the entire side surfaces of the gas supply nozzle are made of quartz including the rough surface part 14, however, the part where the rough surface part 14 is formed in the quartz surface is not particularly limited, and the area around the injection tip opening 11 of the gas supply nozzle (that is, the upper part of the gas supply nozzle standing in the reaction furnace 1) may be the rough surface part. Preferably, 50% or more of the surface area of the contacting surface with the internal space of the bell jar is a rough surface part, since such configuration is highly effective for holding the deposited silicon adhered and for suppressing the release of the deposited silicon.

The rough surface part can be formed to the quartz surface of the gas supply nozzle of the present disclosure using a known method. For example, a sandblast treatment which applies polishing sand on the quartz surface may be mentioned.

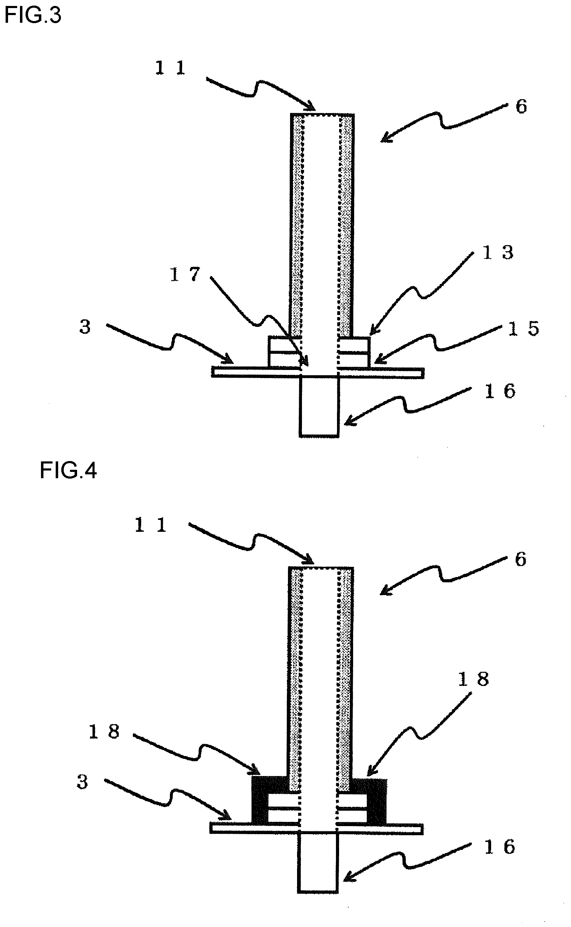

Also, the gas supply nozzle 6 is used while it is fixed to the base plate 3. FIG.3 is a cross sectional view of the structure of which the gas supply nozzle 6 is placed in the reaction furnace for producing the polycrystalline silicon rod. The gas supply nozzle 6 is connected to the base plate 3 by a base plate joint part 15 surrounding a base plate gas supply opening 17 provided to the base plate 3 and by the joint part 13 of the gas supply nozzle 6. The reaction furnace has a gas supplying part connecting to the internal space of the furnace, and the silicon deposition raw material gas is supplied from the gas supplying part 16 to the supply nozzle 6, and then the silicon deposition raw material gas is supplied into the reaction furnace 1 through the injection tip opening 11. In the structure shown in FIG.3, the gas supply nozzle 6 is not re-attachable as it is fixed using the base plate joint part 15 and the joint part 13 of the gas supply nozzle 6. However, as shown in FIG.4, preferably, the gas supply nozzle 6 may be re-attachable by fixing the base plate joint part 15 and the joint part 13 of the gas supply nozzle 6 using a fixing member 18.

After silicon deposition, the metal compounds, silicon and so on are deposited and adhered on the gas supply nozzle. When the gas supply nozzle is made of a carbon member, since the carbon member has open pores with complicated shapes, the above-mentioned adhered materials are taken inside the carbon member. As a result, it is impossible to thoroughly remove the adhered materials. The carbon member may be washed using pure water or alcohol such as isopropyl alcohol (IPA). However, when alcohol such as IPA is used for washing, residual organic materials may evaporate during silicon deposition, and such organic materials may become a source of carbon contamination when re-using the gas supply nozzle. When pure water is used for washing, it may be an oxygen source, and the surface oxidation of the silicon core wire may occur. Further, the by-products such as $CO_2$ may be generated and may cause carbon contamination. Also, in either case of using such washing liquid, due to the open pores with complicated shape of the carbon member, it may be difficult to discharge trace amounts of metal compounds in the open pores.

In the gas supply nozzle of the present disclosure, the adhered materials are on the surface of the quartz member, thus, when the gas supply nozzle is detached, the adhered materials can be removed by washing the gas supply nozzle. Further, after the adhered materials are washed away, the gas supply nozzle can be placed back into the reaction furnace for producing the polycrystalline silicon rod, and it can be repeatedly used for silicon deposition. As for the method for washing, it only needs to release the adhered materials from the quartz surface, and for example, it may be a method of blowing ultra-pure water onto the quartz surface, or a method of removing the adhered materials by applying physical abrasion while immersing the gas supply nozzle into a container filled with ultra-pure water. It is also possible to use a method of solvent washing by using alkaline solution to the surface with excessive ten-point average roughness Rz mentioned in above, however, this method has concerns such as a cost of the washing solution, and a contamination risk to the polycrystalline silicon due to the residue of the washing solution when the gas supply nozzle is re-used.

<Other Configurations>

In the reaction furnace for producing the polycrystalline silicon rod of the above-mentioned disclosure, the silicon deposition raw material gas is supplied from the gas supply nozzle into the reaction furnace for producing the polycrystalline silicon rod. The impurities derived from the materials used for pipes and so on may enter in the supplying path for supplying the silicon deposition raw material gas. When the silicon deposition raw material gas is supplied into the reaction furnace for producing the polycrystalline silicon rod, the impurities scatter in the reaction furnace and adheres onto the polycrystalline silicon during the deposition, hence, in some cases, an impurity concentration in the produced polycrystalline silicon rod may increase. Therefore, when the silicon deposition raw material gas is supplied through the supplying path for supplying the silicon deposition raw material gas into the reaction furnace for producing the polycrystalline silicon rod from the gas supply nozzle, preferably, a removing means for removing the impurities may be placed.

As such removing means, for example, a filter and so on described in WO2021/065685 may be mentioned. By supplying the silicon deposition raw material gas after going through such removing means, the polycrystalline silicon rod with even higher purity can be obtained.

The above-mentioned filter may preferably be provided in the gas supplying nozzle 6 or inside the supplying pipe (not shown in the figure) placed below the gas supply nozzle 6 shown in FIG. 1. Preferably, the filter may be made of a material with a high corrosion resistance against the silicon deposition raw material gas, and for example, it can be made of a stainless steel including 10% or more of Ni; a corrosion resistance material (such as Hastelloy, Inconel 600, Incoloy 800, Incoloy 800H), and ceramics (alumina, titania, zirconia, quartz, silicon carbide, silicon nitride, aluminum nitride, etc.) may be mentioned. Also, since the size of the impurity mixed in the silicon deposition raw material gas has a particle size of about 1 $\mu$m or larger, a filtration accuracy of the filter is preferably 95% or more for the particle size of about 1 $\mu$m or larger. Further, in order to maintain the filtration accuracy of the filter, preferably, the filter is changed to a new filter upon collecting the polycrystalline silicon rod after one or several times of production of the polycrystalline silicon rod. From the point of cost, the filter is re-used after washing. As a method for cleaning the filter, for example, a method for flowing either one of high-purity water, inert gas, air, or a plurality of fluids against the flowing direction of the raw material gas during the polycrystalline silicon rod may be mentioned.

Also, as a widely used method, for preparing the silicon core wire used for production of the polycrystalline silicon rod, method of cutting a part of the polycrystalline silicon rod into a thin rod using a metal blade, or method of cutting a thin rod of a so-called pull rod which is pulled out from a silicon molten liquid and solidified can be mentioned. Since a metal blade is used, the surface of the cross-section and the surrounding thereof are contaminated by metal powder adheres on the surface due to the abrasion of the blade. Thus, in general, the silicon core wire is immersed in a washing tub holding a washing solution made of mixed solution of hydrofluoric acid and nitric acid in order to bring the surface into contact with the washing solution to wash the surface. Then, water rinse, air dry, and so on are carried out, and those which has been thoroughly cleaned is used for production of the polycrystalline silicon rod. However, when the silicon core wire contacts the air including heavy metals, even if the duration of the contact is extremely short, the silicon core wire surface could be contaminated instantly. If the contaminated silicon core wire is used, the heavy metals on the surface of the silicon core wire diffuse into the growing polycrystalline silicon. As a result, purity of the polycrystalline silicon of the polycrystalline silicon rod declines as a whole. Therefore, the atmosphere during the process of placing the silicon core wire in the bell jar is preferably adjusted and maintained under a certain condition.

As for such adjustment means, adjustment of atmosphere described in WO2021/039569 may be mentioned. By placing the silicon core wire inside the bell jar under such atmosphere, the polycrystalline silicon rod with even higher purity can be obtained.

The above-mentioned atmosphere may preferably be an atmosphere adjusted to have a cleanliness of Class 1 to 3 defined by ISO 14644-1. Note that, ISO 14644-1 is an international standard which defines air cleanliness of a clean room. Specifically, it is a standard defining a number of particles each having a particle size of 0.1 $\mu$m or larger in 1 m$^3$, and the cleanliness of Class 1 to 3 defined by ISO 14644-1 shows that the number of particles having a particle size of 0.1 $\mu$m or larger in 1 m$^3$ is 10 to 1000. In order to certainly achieve the above-mentioned, it is preferable to use a means which would eliminate contaminations of foreign objects flowing in when workers and products to be transferred enter into the adjusted atmosphere. For example, when the cleanliness inside the working space for placing the core wire reaches to the pre-defined certain level, and then, the workers and a container to be transferred in which the silicon core wire is housed and sealed in a clean room for cleaning the silicon core wire; it is preferable to wait until the cleanliness reaches back to the same level, and then the container is opened and the silicon core wire is placed inside the bell jar.

<Method For Producing Polycrystalline Silicon Rod>

For producing the polycrystalline silicon rod by using the reaction furnace for producing the polycrystalline silicon rod, electric power is supplied to the silicon core wire to heat the silicon core wire to about 600°C or higher which is the deposition temperature of the polycrystalline silicon. In order to facilitate the deposition of the polycrystalline silicon, in general, heating is carried out at a temperature within a range of 900 to 1200°C.

Regarding the silicon deposition raw material gas, as a silane compound, monosilane, trichlorosilane, silicon tetrachloride, monochlorosilane, dichlorosilane, and so on are used. In general, trichlorosilane may be preferably used. As reducing gas, usually hydrogen gas is used. For example, when trichlorosilane is used as the silane compound to deposit silicon at 1000°C, the supplying amount of chlorosilane gas per surface area of silicon may preferably be within a range of 0.02 to 0.10 mol/cm$^2$·h.

<Polycrystalline Silicon Rod>

When the polycrystalline silicon rod is produced by Siemens method using the reaction furnace for producing the polycrystalline silicon rod of the above-mentioned disclosure, production of the metal compounds as by-products is suppressed during the polycrystalline silicon deposition. As a result, it is possible to industrially produce a high-purity polycrystalline silicon rod in which the amount of the impurity elements are reduced from the initial stage of deposition process (that is, near the silicon core wire of the polycrystalline silicon rod) to the end stage of deposition process (that is, the outer surface area of the polycrystalline silicon rod). Particularly, by using the silicon deposition raw material gas which has passed through the removing means for removing the impurities in the silicon deposition raw material gas, the polycrystalline silicon rod with even higher purity can be obtained. Specifically, the polycrystalline silicon rod having an outer layer part which is 4 mm deep from the surface of the polycrystalline silicon rod has a Fe concentration of 10.0 pptw or less, more preferably 10.0 to 0.5 pptw, and particularly preferably 5.0 to 0.5 pptw; or has a Ni concentration of 2.0 pptw or less, preferably 2.0 to 1.0 pptw, and particularly preferably 1.5 to 1.0 pptw. Further, as a volume average of metal impurity concentration calculated using the actual measured values from each of the core wire part, the middle part, and the outer layer part of the polycrystalline silicon rod, the Fe concentration in terms of volume average is 20 pptw or less, preferably 20.0 to 10.0 pptw, or particularly preferably 10.0 to 5.0 pptw; or a Ni concentration is 2.0 pptw or less, preferably 2.0 to 1.5 pptw, or particularly preferably of 1.5 to 1.0 pptw. Here, the core wire part is an area within 4 mm from the center of the core wire of the polycrystalline silicon rod, and the middle part is an area 2 mm to the inside and outside in a straight-line direction from a mid-point of the shortest straight line connecting the center of the core wire and the outer layer surface of the polycrystalline silicon rod, that is the middle part is an area of total of 4 mm.

Further, by using the reaction furnace for producing the polycrystalline silicon rod of the present disclosure, the polycrystalline silicon rod can have a smooth surface and an appearance damage to the surface of the polycrystalline silicon rod can be suppressed. Here, the appearance damage to the surface of the polycrystalline silicon rod refers to a projection which is projecting from a concentric shape or an oval shape of the core wire rod compared to a normal deposition shape which is a circular shape or oval shape expanding from the core wire rod. As the size of the projection, a diameter is usually within a range of 0.5 to 10 cm (a length which is a longest distance between one end to the other end of the projection when the silicon rod surface is viewed from the above), and a height from the normal deposition surface is 0.5 to 5.0 cm. Specifically, the polycrystalline silicon rod having the number of appearance damages per 100000 $cm^2$ of polycrystalline silicon rod surface is 2 or less, preferably 1 or less, or particularly preferably 0.8 or less can be obtained. A suitable range of the number of appearance damages per 100000 $cm^2$ of polycrystalline silicon rod surface may be 2 to 0, preferably 1 to 0, or particularly preferably 0.8 to 0.

The obtained polycrystalline silicon rod is taken out of the reaction furnace and crushed into a desired size and the part having the appearance damage is removed. Then, the surface is washed, thereby, the polycrystalline silicon rod is used for various purposes.

EXAMPLES

Hereinafter, examples and comparative examples are described for explaining the present disclosure in detail, however, the present disclosure is not limited thereto.

<Measurement of Ten-Point Average Roughness Rz and Arithmetic Average Roughness Ra of Rough Surface Part>

After degreasing a surface of a gas supply nozzle using methylene chloride, Repliset GF-1 (made by Strusers) was applied on an upper end, middle part, and lower end of the rough surface part, and left for curing to form replicas (Resolution of 0.1 $\mu$m) each having a square of about 5 cm $\times$ 5 cm. After curing, the replicas were released from the surface of the gas supply nozzle, and to each of the replicas, using an atomic force microscope (AFM: made by Bruker ASX/Dimension ICON), a line of 90 $\mu$m was drawn in a field of view of 90 $\mu$m, and roughness was analyzed. Then, Rz was calculated using an average value obtained from five points in descending order of the absolute values of the projections with respect to a standard plane, and five points in descending order of the absolute values of the pits. Regarding the replicas cured at each point of the upper end, middle part, and lower end, six lines of 90 $\mu$m were drawn, which were three lines in vertical direction to the field of view and three lines in horizontal direction to the field of view. The obtained Rz were averaged and used. The average value of Rz obtained from the upper end, the middle part, and the lower end was defined as a ten-point average roughness Rz of the gas supply nozzle. Also, using an average value of roughness on the measurement surface in the same field of view as a standard line, the arithmetic average roughness Ra was calculated as an average value of distances from the standard line in the area. Further, the average value of Ra obtained from the upper end, the middle part, and the lower end was defined as the arithmetic average roughness Ra.

<Configuration of Reaction Furnace For Producing Polycrystalline Silicon Rod>

Regarding Examples 1 to 3 and Comparative examples 1 to 3, the reaction furnace for producing the polycrystalline silicon rod having a configuration shown in FIG.1 was prepared. A capacity of a bell jar was 3 $m^3$, silicon wires in five pairs (that is, total of ten silicon wires) were placed on a base plate such that the silicon wires were in an inverted U-shape. Six gas supply nozzles, each having the configuration shown in FIG.2 and having an inner diameter of 12.7 mm and a height from the base plate to an injection tip opening of 370 mm, were placed in the bell jar. The gas supply nozzles were placed throughout the upper surface of the base plate taking equal distance between each other.

<Production of Polycrystalline Silicon Rod>

For producing the polycrystalline silicon, electric power was supplied to the silicon core wire to heat it to about 1000°C, a mixed gas of trichlorosilane and hydrogen was used as a silicon deposition raw material gas, and this was supplied from a gas supply nozzle at a speed of 700 Nm$^3$/h when it was at a maximum speed, thereby, a silicon deposition reaction was performed for 100 hours using Siemens method. As a result, ten polycrystalline silicon rods each having a thickness of about 120 mm were obtained.

Comparative Example 1

A polycrystalline silicon rod was produced using a gas supply nozzle which was made of carbon not including a rough surface part.
After the deposition was completed, an annealing step was performed by heating at about 1050°C for 1 hour under hydrogen atmosphere to remove distortion of silicon obtained around the end stage of silicon deposition process. From the early stage of deposition process, silicon deposition was confirmed on the gas supply nozzle, which becomes high temperature. Appearance damage to the surface of the obtained polycrystalline silicon rod did not occur.
A sample of cylinder rod shape was taken using a drill so as to include the core wire from the polycrystalline silicon rod, and it was cut into a core wire part, an outer layer part, and a middle part. Then, each of these were dissolved and a heavy metal concentration of the above-mentioned polycrystalline silicon rod was measured using ICP-MS. Among the measured results, a Fe concentration in terms of volume average was 27.2 pptw, or a Fe concentration of the outer layer part was 47.5 pptw.

Example 1

A gas supply nozzle made of quartz which the entire outer surface was carried out with a sandblast processing using a polishing sand of a granularity of #180 was used. A ten-point average roughness Rz of the rough surface part formed by the sandblast processing was 4.1 $\mu$m, and an arithmetic average roughness Ra was 2.5 $\mu$m.
After the deposition was completed, an annealing step was performed by heating at about 1050°C for 1 hour under hydrogen atmosphere to remove distortion of silicon obtained around the end stage of silicon deposition process. The deposition of silicon on the gas supply nozzle was not confirmed around the early stage of deposition process, and the silicon deposition was confirmed from the mid-stage of deposition process. Appearance damages to the surface of the obtained polycrystalline silicon rod did not occur. As a result of measurement of the heavy metal concentration included in the polycrystalline silicon, a Fe concentration in terms of volume average was 10.2 pptw, and also particularly a Fe concentration at the outer layer part was 12.9 pptw. The volume average of the Fe concentration was decreased to about 40% compared to Comparative example 1, particularly, the Fe concentration included in the outer layer part around the end stage of deposition process was reduced to about 25%.
When this gas supply nozzle was washed with 500 ml of ultra-pure water, silicon which had adhered on the surface was removed. Also, as a result of ICP-AES measurement of the washing water after use, Fe and Ni were detected. That is, it was confirmed that Fe and Ni were in the removed silicon.

Example 2

The gas supply nozzle which was washed using ultra-pure water in Example 1 was placed in the bell jar, and the polycrystalline silicon rod was produced. After the deposition was completed, an annealing step was performed by heating at about 1050°C for 1 hour under hydrogen atmosphere to remove distortion of silicon obtained around the end stage of silicon deposition process. Similar to Example 1, the deposition of silicon on the gas supply nozzle was not confirmed around the early stage of the deposition process, and the silicon deposition was confirmed from the mid-stage of deposition process.
There was no appearance damage to the surface of the obtained polycrystalline silicon rod. Also, after measuring the heavy metal concentration included in the polycrystalline silicon, a Fe concentration in terms of volume average was 9.4 pptw, or the outer layer part had a Fe concentration of 11.7 pptw. Even when the gas supply nozzle was repeatedly used, by performing a washing step, it was confirmed that a quality of the produced polycrystalline silicon can be maintained.

Example 3

A gas supply nozzle made of quartz which the entire outer circumference surface was carried out with a sandblast processing was used. A rough surface part formed by the sandblast processing had a ten-point average roughness Rz

of 1.1 μm, and an arithmetic average roughness Ra of 0.88 μm. After the deposition was completed, an annealing step was performed by heating at about 1050°C for 1 hour under hydrogen atmosphere to remove distortion of silicon obtained around the end stage of silicon deposition process. Similar to Example 1, the deposition of silicon on the gas supply nozzle was not confirmed around the early stage of the deposition process, and the silicon deposition was confirmed from the mid-stage of deposition process. There was no appearance damage to the surface of the obtained polycrystalline silicon rod.

When the gas supply nozzle was taken out from the reaction furnace, adhesion of silicon on the surface of the rough surface part was confirmed, however, the amount of the adhered silicon was half or less compared to that on the gas supply nozzles used in Example 1 and Example 2 in which the surface was much rougher than Example 3 by sandblast processing. Also, after measuring the heavy metal concentration included in the polycrystalline silicon, a Fe concentration in terms of volume average was 13.9 pptw, and the outer layer part had a Fe concentration of 10.5 pptw.

Comparative Example 2

A gas supply nozzle made of quartz which a sandblast processing was not carried out was used. A ten-point average roughness Rz of the surface was 0.02 μm, and an arithmetic average roughness Ra was 0.01 μm. After completing the deposition, an annealing step was performed by heating at about 1050°C for 1 hour under hydrogen atmosphere to remove distortion of silicon obtained around the end stage of silicon deposition process. Similar to Example 1, the deposition of silicon on the gas supply nozzle was not confirmed around the mid-stage of the deposition process, and the silicon deposition was confirmed around the end stage of deposition process. The appearance abnormality of projection form was confirmed on the surface of the obtained polycrystalline silicon rod. When the gas supply nozzle was taken out of the reaction furnace, silicon was slightly adhered on the surface. That is, most of silicon which was verified during the deposition scattered, and the above-mentioned appearance abnormality was formed. Result of measurement of the heavy metal concentration included in the polycrystalline silicon showed that a Fe concentration in terms of volume average was 8.5 pptw, or the outer layer part had a Fe concentration of 6.6 pptw. The measurement result of the heavy metal concentration included in the above-mentioned appearance abnormalities showed that a Fe concentration of 2179 pptw.

Also, the number of appearance abnormalities on the surface of the polycrystalline silicon rod were 3 in the area of about 100000 cm$^2$ which was measured using a method described in below.

Comparative Example 3

The surface of the gas supply nozzle after Comparative Example 1 was wiped, and then the gas supply nozzle was placed in the bell jar and the production of the polycrystalline silicon was carried out. After completing the deposition, an annealing step was performed by heating at about 1050°C for 1 hour under hydrogen atmosphere to remove distortion of silicon obtained around the end stage of silicon deposition process. The deposition of silicon was confirmed on the gas supply nozzle which was at high temperature from the beginning of the deposition process. There was no appearance damage to the surface of the obtained polycrystalline silicon rod. Also, result of measurement of the heavy metal concentration included in the polycrystalline silicon showed that a Fe concentration in terms of volume average was 29.2 pptw, and the outer layer part had a Fe concentration of 48.5 pptw.

<Configuration of Reaction Furnace For Producing Polycrystalline Silicon Rod With Filter>

Regarding Comparative Example 4 and Examples 4 and 5, the configuration of the reaction furnace for producing the polycrystalline silicon rod included a filter, made of SUS316L for removing impurities, installed between the gas supply nozzle and the connecting part of the base plate. Also, the filter had a filtration accuracy capable of removing 90% or more of particles each having a particle size of 0.3 μm or larger. Further, atmosphere where the silicon core wire was placed in the bell jar was confirmed to be an atmosphere adjusted within a cleanliness of Class 1 to 3 defined by ISO14644-1. The atmosphere was maintained at a cleanliness that the number of particles each having a size of 0.1 μm or larger in 1 m$^3$ was 1000 or less.

<Preparation of Analysis Sample of Polycrystalline Silicon Rod>

A level of contamination by metal impurities was verified for each of the polycrystalline silicon rods produced in Comparative Example 4 Examples 4 and 5. A measurement for verifying the contamination level was performed as described in below. The polycrystalline silicon rod was cut out at an area near the mid-point in a longitudinal direction of the polycrystalline silicon rod, and the polycrystalline silicon rod was cut into a circular column shape having a diameter of 19 mm and a length of 120 mm along a horizontal direction perpendicular to a longitudinal direction of the polycrystalline silicon rod.

First, the polycrystalline silicon rod was cut from the side surface so that it is cut perpendicularly to the silicon core wire and to include the silicon core wire, thereby, a core ring rod of a circular cylinder shape was obtained. Such cut can be done by using a core drill. A circular column of the polycrystalline silicon obtained as such included the depositions of all stages, that is, from immediately after the start of deposition process to right before the deposition process was ended. First, a crystal shape on the surface of the circular column was observed to verify the boundary between the core wire and a deposition layer. Then, along the shortest straight line between the core wire center and the circular column end, the outer layer part which was 4 mm from the end side, the middle part which was an area 2 mm in and out from the mid-point of the straight line, and the core wire part which was an area 4 mm towards the end from the core wire center were cut; thereby, three samples for measurement were obtained. A crystal cutter (OD saw (product name): made by MARUTO INSTRUMENT CO.,LTD) was used.

<Heavy Metal Concentration in Polycrystalline Silicon Rod>

The sample taken out as described in above was etched using a mixed acid solution of hydrofluoric acid and nitric acid to remove the metal contaminations formed during cutting, and a mass measurement was carried out. Then, the sample was set inside PTFE made vapor phase decomposition container, and the container was heated on a hot plate, then, a vapor phase decomposition in fluoronitric acid was carried out. After cooling the container, a residue part is collected using 1 ml of sulfuric acid, and a concentration of each metal was quantified using ICP-MS (Agilent 8800). From the obtained actual measured value, a bulk metal concentration was calculated using the below formula.

[Formula 1]

$$Q = \frac{(C - C_b)}{W} \times L$$

Q: A bulk metal concentration [pptw] at each part of silicon.
C: Actual measured value [ng/L].
Cb: Operational Blank value [ng/L].
W: A weight of silicon after the pre-treatment [g].
L: An amount of sulfuric acid used for collection [L].

Using the actual value of the bulk metal concentration of each part obtained as mentioned in above, a volume average value was calculated.

[Formula 2]

$$Ave = \frac{sin + mid}{2} \times \left(\frac{r}{2}\right)^2 + \left\{\frac{mid + as}{2} \times \left[r^2 - \left(\frac{r}{2}\right)^2\right]\right\}$$

Ave: A bulk heavy metal concentration volume average of silicon [pptw].
sin: A bulk metal concentration of a silicon core wire part [pptw].
mid: A bulk metal concentration of a silicon middle part [pptw].
as: A bulk metal concentration of a silicon outer layer part [pptw].

<Method for Measuring Appearance Abnormality of Polycrystalline Silicon Rod>

For all of the polycrystalline silicon rods of a production batch which were taken out from the bell jar, the number of appearance abnormalities were counted. For each polycrystalline silicon rod, the number of appearance abnormalities per unit surface area was measured using a calculated surface area which was calculated from a length of the polycrystalline silicon rod and an average value obtained by measuring the diameters at three positions including a center part, mid part between the center part and upper end, and mid part between the center part and lower end in the longitudinal direction of the polycrystalline silicon rod.

Comparative Example 4

After used in Comparative Example 2, the gas supply nozzle made of quartz not performed with the sandblast processing was washed using ultra-pure water, and it was placed in the reaction furnace with filter; then, three batches of polycrystalline silicon rods were produced by the above-mentioned production condition. The gas supply nozzle was washed using ultra-pure water after each production of batch; and then, it was re-used. A heavy metal concentration included in the polycrystalline silicon rod of each production batch was measured. Results are shown in Table 1. As an average of three batches of production, a Fe concentration in terms of volume average was 11.2 pptw, and particularly a Fe concentration in the outer layer part was 6.6 pptw. Compared to Comparative Example 1, the volume average of Fe concentration decreased to about 13%, and particularly, the Fe concentration included in the outer layer part around the end stage of deposition process was decreased to about 1%. Since the sandblast was not carried out, numerous appearance abnormalities were formed, and the number of appearance abnormalities per 100000 cm$^2$ was 3.

[Table 1]

| Comparative example 4 | | | | | |
|---|---|---|---|---|---|
| Batch | Measured Parts | Bulk heavy metal concentration (pptw) | | | |
| | | Cr | Fe | Ni | Cu |
| Batch 1 | Outer layer part | 4.7 | 7.1 | 4.3 | 0.9 |
| | Volume average | 6.7 | 11.0 | 2.5 | 0.5 |
| Batch 2 | Outer layer part | 6.4 | 5.8 | 1.7 | 2.1 |
| | Volume average | 6.4 | 11.3 | 1.5 | 0.9 |
| Batch 3 | Outer layer part | 7.5 | 6.9 | 1.7 | 0.3 |
| | Volume average | 6.9 | 11.4 | 1.1 | 0.4 |
| Average of Batches | Outer layer part | 6.2 | 6.6 | 2.6 | 1.1 |
| | Volume average | 6.7 | 11.2 | 1.7 | 0.6 |

Example 4

After used in Example 3, the gas supply nozzle made of quartz which the sandblast processing was carried out was washed using ultra-pure water, and it was placed in the reaction furnace with filter. Then, three batches of polycrystalline silicon rods were produced by the above-mentioned production condition. The gas supply nozzle was washed using ultra-pure water after each production of batch, and then it was re-used. The filter for removing the impurities included in the silicon deposition raw material gas was washed after each production of batch, and then it was re-used. After confirming that the number of particles each having a size of 0.1 $\mu$m or larger in 1 m$^3$ was 1000 or less which was a standard for a cleanliness inside the housing space for placing the core wire in the bell jar, a worker and a container to be transferred which was housed and sealed in a clean room for silicon core wire washing step enters inside the housing space. Then, as a step to verify that foreign objects entered when the workers and an object to be transferred entered a housing work space had been removed, the number of particles each having a size of 0.1 $\mu$m or larger in 1 m$^3$ was verified to be 1000 or less after entering the room, and the transferring container was opened. Then, the core wire was placed into the bell jar. Results of measurements of the heavy metal concentration included in the polycrystalline silicon rod of each production batch are shown in a table. As an average of three batches of production, a Fe concentration in terms of volume average was 7.6 pptw, and particularly, a Fe concentration in the outer layer part was 1.1 pptw. Compared to Comparative Example 1, the volume average of Fe concentration decreased to about 28%, and particularly, the Fe concentration included in the outer layer part around the end of deposition process was decreased to about 2%. Also, few appearance abnormalities were formed, and the number of appearance abnormalities per 100000 cm$^2$ was 0.7.

[Table 2]

| Example 4 | | | | | |
|---|---|---|---|---|---|
| Batch | Measured parts | Bulk heavy metal concentration (pptw) | | | |
| | | Cr | Fe | Ni | Cu |
| Batch 1 | Outer layer part | 1.3 | 1.2 | 1.1 | 0.3 |
| | Volume average | 9.2 | 9.4 | 2.0 | 0.2 |
| Batch 2 | Outer layer part | 5.9 | 1.0 | 1.2 | 0.2 |
| | Volume average | 7.5 | 2.1 | 0.9 | 0.2 |
| Batch 3 | Outer layer part | 5.9 | 1.0 | 1.2 | 0.2 |
| | Volume average | 7.9 | 11.3 | 2.1 | 0.6 |
| Average of Batches | Outer layer part | 4.4 | 1.1 | 1.2 | 0.2 |
| | Volume average | 8.2 | 7.6 | 1.7 | 0.4 |

Example 5

After used in Example 2, the gas supply nozzle made of quartz which the sandblast processing was carried out was washed using ultra-pure water, and it was placed in the reaction furnace with filter. Then, three batches of polycrystalline silicon rods were produced by the above-mentioned production condition. The gas supply nozzle was washed using ultra-pure water after each production of batch, and then it was re-used. The filter for removing the impurities included in the silicon deposition raw material gas was washed after each batch production, and then it was used repeatedly. After confirming that the number of particles each having a size of 0.1 $\mu$m or larger in 1 m$^3$ was 1000 or less which was a standard of the cleanliness inside a housing process space for placing the core wire in the bell jar, a worker and a container to be transferred which was housed and sealed in a clean room for silicon core wire washing step enters inside the housing work space. Then, as a step to verify that foreign objects which entered when the workers and an object to be transferred entered the housing work space had been removed, the number of particles each having a size of 0.1 $\mu$m or larger in 1 m$^3$ was verified again to be 1000 or less after entering, and the container was opened. Then, the core wire was placed into the bell jar. Results of measurements of the heavy metal concentration included in the polycrystalline silicon rod of each production batch are shown in a table. As an average of three batches of production, a Fe concentration in terms of volume average was 10.3 pptw, and particularly, a Fe concentration in the outer layer part was 3.5 pptw. Compared to Comparative Example 1, the volume average of Fe concentration decreased to about 38%, and particularly, the Fe concentration included in the outer layer part around the end of deposition process was decreased to about 7%. Also, no appearance abnormality was formed.

[Table 3]

| Example 5 | | | | | |
|---|---|---|---|---|---|
| Batch | Measured parts | Bulk heavy metal concentration (pptw) | | | |
| | | Cr | Fe | Ni | Cu |
| Batch 1 | Outer layer part | 2.2 | 2.7 | 3.1 | 0.5 |
| | Volume average | 4.9 | 13.0 | 2.9 | 0.4 |
| Batch 2 | Outer layer part | 4.5 | 4.1 | 2.4 | 0.6 |
| | Volume average | 5.5 | 3.8 | 1.6 | 0.1 |
| Batch 3 | Outer layer part | 3.8 | 3.8 | 2.4 | 0.6 |
| | Volume average | 5.4 | 14.2 | 2.2 | 0.2 |
| Average of Batches | Outer layer part | 3.5 | 3.5 | 2.7 | 0.6 |
| | Volume average | 5.3 | 10.3 | 2.2 | 0.3 |

**REFERENCE SIGNS LIST**

1; Reaction furnace
2; Bell jar
3; Base plate
4; Silicon core wire
5; Electrode pairs
6; Gas supply nozzle
7: Polycrystalline silicon rod
11: Injection tip opening
12: Gas supplying part
13: Joint part
14: Rough surface part
15: Base plate joint part
16: Gas supplying part
17: Base plate gas supply opening
18: Fixing member

**Claims**

1. A reaction furnace for producing a polycrystalline silicon rod, comprising;

    a bell jar and a base plate which seal inside of the reaction furnace, wherein
    the base plate comprises a plurality of electrode pairs holding a silicon core wire and supplying electric power
    to the silicon core wire, and
    the base plate comprises a plurality of gas supply nozzles, each having an injection tip opening facing upwards,
    for supplying a silicon deposition raw material gas to an internal space of the bell jar, wherein
    at least part of a contacting surface of the gas supply nozzles contacting the internal space of the bell jar is
    configured of quartz including a rough surface part having a ten-point average roughness Rz of 1.0 to 5.0 $\mu$m.

2. The reaction furnace for producing the polycrystalline silicon rod according to claim 1, wherein 50% or more of a
surface area of the contacting surface of the gas supply nozzles is configured of quartz including the rough surface
part.

3. The reaction furnace for producing the polycrystalline silicon rod according to claim 1, wherein an arithmetic average
surface roughness Ra of the rough surface part is 0.3 to 3.0 $\mu$m.

4. The reaction furnace for producing the polycrystalline silicon rod according to claim 1, comprising;

    a supplying pipe for supplying the silicon deposition raw material gas to the gas supply nozzles, and
    at least one of the gas supply nozzles and the supplying pipe comprise a removing means for removing impurities
    mixed in the silicon deposition raw material gas.

5. A gas supply nozzle for supplying a silicon deposition raw material gas from an injection tip opening into an internal
space of a bell jar, wherein at least part of a contacting surface of the gas supply nozzle contacting the internal
space of the bell jar is configured of quartz including a rough surface part having a ten-point average roughness Rz
of 1.0 to 5.0 $\mu$m.

6. The gas supply nozzle according to claim 5, wherein 50% or more of a surface area of the contacting surface of the
gas supply nozzles is configured of quartz including the rough surface part.

7. The gas supply nozzle according to claim 5 or 6, wherein an arithmetic average surface roughness Ra of the rough
surface part is 0.3 to 3.0 $\mu$m.

8. A method for producing a polycrystalline silicon rod, comprising steps of;

placing a silicon core wire inside a bell jar, and
injecting a silicon deposition raw material gas onto the silicon core wire while supplying electric power to the silicon core wire to deposit polycrystalline silicon on the silicon core wire, wherein
the method for producing the polycrystalline rod uses the reaction furnace for producing the polycrystalline silicon rod according to any one of claims 1 to 4.

9. The method for producing the polycrystalline silicon rod according to claim 8, comprising steps of;

removing a gas supply nozzle in the reaction furnace for producing the polycrystalline silicon rod after the polycrystalline silicon is deposited, and
washing a surface of the removed gas supply nozzle contacting an internal space of the bell jar.

10. The method for producing the polycrystalline silicon rod according to claim 8, wherein impurities mixed in a silicon deposition raw material gas are removed using a removing means, and the silicon deposition raw material gas from which the impurities are removed is injected onto the silicon core wire.

11. The method for producing the polycrystalline silicon rod according to claim 8, wherein the polycrystalline silicon rod is produced under an atmosphere satisfying a cleanliness of Class 1 to 3 defined by ISO 14644-1.

12. A polycrystalline silicon rod, wherein an outer layer part which is 4 mm deep from a surface has a Fe concentration of 10.0 pptw or less, or a Ni concentration of 2.0 pptw or less.

13. The polycrystalline silicon rod according to claim 12, wherein a volume average of a Fe concentration is 20 pptw or less, or a Ni concentration is 2.0 pptw or less which are calculated from actual measured values in a core wire part, a middle part, and the outer layer part.

14. The polycrystalline silicon rod according to claim 12 or 13, wherein a foreign object having a size of 0.5 to 10 cm and a height of 0.5 to 5.0 cm is two or less per 100000 $cm^2$ surface area of the polycrystalline silicon rod.

FIG.1

Exhaust gas      Raw material gas

FIG.2

FIG.3

FIG.4

## INTERNATIONAL SEARCH REPORT

| International application No. |
|---|
| **PCT/JP2023/000746** |

**A.    CLASSIFICATION OF SUBJECT MATTER**

*C01B 33/035*(2006.01)i
FI:    C01B33/035

According to International Patent Classification (IPC) or to both national classification and IPC

**B.    FIELDS SEARCHED**

Minimum documentation searched (classification system followed by classification symbols)

C01B33/035

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JSTChina/JST7580 (JDreamIII)

**C.    DOCUMENTS CONSIDERED TO BE RELEVANT**

| Category* | Citation of document, with indication, where appropriate, of the relevant passages | Relevant to claim No. |
|---|---|---|
| Y | WO 2019/194045 A1 (TOKUYAMA CORP.) 10 October 2019 (2019-10-10) claims, paragraphs [0014], [0015], [0035], fig. 6 | 12, 13 |
| A | | 1-11, 14 |
| Y | WO 2021/065685 A1 (TOKUYAMA CORP.) 08 April 2021 (2021-04-08) claims, paragraphs [0073]-[0079] | 12, 13 |
| A | | 1-11, 14 |
| X | WO 2021/039569 A1 (TOKUYAMA CORP.) 04 March 2021 (2021-03-04) paragraph [0051] | 12, 13 |

☐ Further documents are listed in the continuation of Box C.        ☑ See patent family annex.

| | | |
|---|---|---|
| *    Special categories of cited documents: | "T" | later document published after the international filing date or priority date and not in conflict with the application but cited to understand the principle or theory underlying the invention |
| "A"    document defining the general state of the art which is not considered to be of particular relevance | | |
| "E"    earlier application or patent but published on or after the international filing date | "X" | document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O"    document referring to an oral disclosure, use, exhibition or other means | | |
| "P"    document published prior to the international filing date but later than the priority date claimed | "&" | document member of the same patent family |

| Date of the actual completion of the international search | Date of mailing of the international search report |
|---|---|
| **13 March 2023** | **28 March 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/000746**

| Patent document cited in search report | | | Publication date (day/month/year) | Patent family member(s) | | | Publication date (day/month/year) |
|---|---|---|---|---|---|---|---|
| WO | 2019/194045 | A1 | 10 October 2019 | US | 2021/0054499 | A1 | |
| | | | | claims, paragraphs [0018], [0019], [0044], fig. 6 | | | |
| | | | | EP | 3763673 | A1 | |
| | | | | CN | 111936420 | A | |
| | | | | KR | 10-2020-0139160 | A | |
| WO | 2021/065685 | A1 | 08 April 2021 | EP | 4039644 | A1 | |
| | | | | claims, paragraphs [0072]-[0079] | | | |
| | | | | CN | 114502509 | A | |
| | | | | KR | 10-2022-0073750 | A | |
| WO | 2021/039569 | A1 | 04 March 2021 | EP | 4005977 | A1 | |
| | | | | paragraph [0050] | | | |
| | | | | CN | 114206777 | A | |
| | | | | KR | 10-2022-0052915 | A | |

Form PCT/ISA/210 (patent family annex) (January 2015)

**EP 4 434 939 A1**

**REFERENCES CITED IN THE DESCRIPTION**

**Patent documents cited in the description**

- JP 2013063884 A
- JP 5368909 B
- JP 5182608 B
- JP 5428692 B
- JP 3357675 B
- WO 2021065685 A
- WO 2021039569 A